# EUROPÄISCHE PATENTSCHRIFT

(11) **EP 1 802 188 B1**
(45) Veröffentlichungstag und Bekanntmachung des Hinweises auf die Patenterteilung: **19.03.2008**
(21) Anmeldenummer: 05028353.0
(22) Anmeldetag: 23.12.2005
(51) Int. Cl.: H05K 7/14

(54) **Steckbaugruppe mit Hebelziehgriff**
Plugin unit with extraction lever
Bloc enfichable avec poignée d'extraction

(43) Veröffentlichungstag der Anmeldung: 27.06.2007
(73) Patentinhaber: Schroff GmbH, D-75334 Straubenhardt (DE); Nokia Siemens Networks GmbH & Co. KG, 81541 München (DE)
(72) Erfinder: Günther, Hans-Ulrich, 76327 Pfinztal (DE); Haag, Volker, 75323 Bad Wildbad (DE); Hauber, Stefan, 82041 Oberhaching (DE); Joist, Michael, 76571 Gaggenau (DE); Pfeifer, Klaus, 76199 Karlsruhe (DE)
(74) Vertreter: Petirsch, Markus

(56) Entgegenhaltungen:
- DE-C1- 19 507 712
- DE-C1- 19 904 763
- US-A1- 2002 182 909
- US-A1- 2005 274 592

## Beschreibung

Die vorliegende Erfindung betrifft eine Steckbaugruppe zum Einschieben und Ausziehen in bzw. aus einem Baugruppenträger, der wenigstens eine vordere Profilschiene aufweist, mit einer Frontplatte und einem im Frontbereich der Steckbaugruppe gelagerten Hebelziehgriff mit Griffarm. DE 199 04 763 C1 offenbart eine Steckbaugruppe nach dem Oberbegriff von Anspruch 1.

Um Steckbaugruppen in einem Baugruppenträger einzuschieben oder um sie aus dem Baugruppenträger wieder herauszuziehen, sind im Stand der Technik seit langem Einschiebe- und Ausziehvorrichtungen bekannt. Zum Einschieben und Ausziehen der Steckbaugruppen wurden in der Vergangenheit unterschiedliche Hebelziehgriffe und Hebel entwickelt. Die zum Einschieben und Herausziehen aufzuwendenden Kräfte hängen heute im Wesentlichen von der Polzahl der Steckverbinder ab, die auf der Rückseite der Steckbaugruppe angeordnet sind und mit entsprechenden Steckverbindern an der sogenannten Backplane des Baugruppenträgers verbunden werden. Diese Steckerleisten weisen immer mehr Pole auf, so dass die aufzubringenden Kräfte zum Einschieben und Herausziehen immer größer werden. Deshalb müssen die Hebel und Hebelziehgriffe immer robuster ausgebildet werden. Durch die Verwendung von hochpoligen Steckverbindern an der Rückseite der Steckbaugruppen kommt es durch die hohen Steckkräfte zu elastischen Verformungen von Einzelkomponenten der gesamten Steckbaugruppe.

Beim Einschiebvorgang der Steckbaugruppe in den Baugruppenträger wird der Hebelweg des Hebelziehgriffs entweder durch eine im Frontbereich der Steckbaugruppe angeordnete Frontplatte oder einen separaten Anschlag begrenzt. Durch die Begrenzung des Hebelwegs des Hebelziehgriffs wird das Einschieben nicht vollständig beendet, da die hohen Steckkräfte an den vielpoligen Steckverbindern nicht überwunden werden können. Folglich tritt ein elastisches Zurückfedern der Steckbaugruppe bzw. eine Rückverformung der Steckbaugruppe auf. Die Steckbaugruppe schließt dann nicht bündig mit dem Baugruppenträger ab; zwischen der Steckbaugruppe und dem Baugruppenträger wird im Frontbereich ein Spalt sichtbar ausgebildet, was für die Schirmwirkung des Baugruppenträgers nachteilig ist.

Moderne Baugruppen werden im passiven Zustand in den Baugruppenträger eingeschoben. Erst in vollständig eingeschobenem Zustand werden sie aktiv geschaltet, indem ein auf der Steckbaugruppe angeordneter Schalter betätigt wird. Wird die Steckbaugruppe nicht vollständig in den Baugruppenträger eingeschoben oder findet ein Zurückfedern der Steckbaugruppe statt, so wird der Schalter nicht oder nicht einwandfrei betätigt. Die Steckbaugruppe wird entweder nicht aktiv geschaltet oder es kann zu einem Prellen des Schalters kommen.

Beim Versuch den Hebelziehgriff über seine Begrenzung hinaus zu verschwenken können aufgrund des Überhubs Beschädigungen des Hebels, der Frontplatte und des Anschlags auftreten oder Verformungen einzelner Komponenten hervorgerufen werden.

Im Telekommunikationsbereich, siehe z.B. US 2005/0274592 A1, sind Steckbaugruppen mit einem normgerechten Hebel bekannt, die als sogenannte ATCA-Hebel bezeichnet sind. Diese Steckbaugruppen weisen z.B. in ihrem Frontbereich zusätzlich einen magnetischen Anschlag auf, an dem der metallisch ausgebildete Hebelziehgriff im eingeschobenen Zustand der Steckbaugruppe anliegt und von dem Anschlag in seiner Sollposition gehalten wird. Wird die Steckbaugruppe aufgrund der hohen Steckkräfte der rückseitigen Steckverbinder nicht vollständig eingeschoben, so kommt es auch hier zu einem Zurückfedern oder einer Rückverformung der Steckbaugruppen. Der Hebel wird dann nicht vom Magneten in seiner Endposition gehalten. Ein Verschwenken über die normale Endposition hinaus führt ebenfalls zu Beschädigungen des Anschlags und/oder der Steckbaugruppe.

Aufgabe der vorliegenden Erfindung ist nun, die Nachteile im Stand der Technik zu überwinden und einen Hebelziehgriff vorzuschlagen, der einen gewissen Überhub zulässt, um ein Zurückfedern der gesamten Baugruppe und eine Beschädigung der Steckbaugruppe oder des Hebels zu vermeiden.

Gelöst wird die vorliegende Aufgabe durch eine Steckbaugruppe mit den Merkmalen des Patentanspruchs 1.

Die erfindungsgemäße Steckbaugruppe zum Einschieben und Ausziehen in bzw. aus einem Baugruppenträger, der wenigstens eine vordere Profilschiene aufweist, mit einer Frontplatte und einem im Frontbereich der Steckbaugruppe schwenkbar gelagertem Hebelziehgriff mit einem Griffarm weist eine elastische Zunge am Griffarm des Hebelziehgriffs auf. Die Zunge haftet in eingeschobenem Zustand der Steckbaugruppe von außen an der Frontplatte an, wodurch der Hebelziehgriff in seiner Soll-Endposition fixiert ist. Die elastische Zunge des Griffarms ist federnd ausgebildet. Sie kann auch als Federzunge konzipiert sein. Damit hat sie auch dämpfende Eigenschaften, so dass Kräfte, die auf den Hebelziehgriff wirken, nicht vollständig, sondern nur abgeschwächt von der elastischen Zunge auf die Steckbaugruppe übertragen werden. Durch Ausbildung der elastischen Zunge am Hebelziehgriff ist ein Weiterschwenken des Hebelziehgriffs über seine Soll-Endposition hinaus möglich. Beschädigungen durch zu hohe Kräfte, die auf die Steckbaugruppe wirken, werden so zuverlässig verhindert.

Die elastische Zunge des Griffarms ermöglicht auch ein Rückfedern des Hebelziehgriffs in seine Soll-Endposition, nachdem der Hebelziehgriff über diese Soll-Endposition hinaus in die maximale Endposition verschwenkt wurde. Nach diesem Überhub wird der Hebelziehgriff also automatisch in seine Soll-Endposition zurück bewegt. Dabei bleibt die elastische Zunge stets an der Frontplatte anhaften. Der Hebelziehgriff wird dann in der Soll-Endposition fixiert.

Vorteilhafterweise ist die Zunge aus elastisch verformbarem Material gebildet. Werden Kräfte auf die Zunge des Hebelziehgriffs übertragen, so verformt sich das Material elastisch. Damit kann eine starre Verbindung zwischen der Zunge und dem Hebelziehgriff bestehen, die nicht elastisch sein muss.

Die elastischen Rückfedereigenschaften des Hebels, die durch geeignete Wahl des Materials festgelegt werden, sind so gewählt, dass der Hebelziehgriff nach dem Überhub von selbst in seine Soll-Endposition zurückfedert. Der Hebelziehgriff wird dann in dieser Position sicher gehalten. Das Gleiche gilt auch bei einer Schock- und Vibrationsbeaufschlagung des Baugruppenträgers, so dass auch bei Stössen auf den Baugruppenträger der Hebelziehgriff zuverlässig in seiner Soll-Endposition fixiert bleibt.

Durch geeignete Wahl der Dimensionen des Hebels und der Zunge wird die Elastizität vorrangig in Betätigungsrichtung erzielt, während der Hebelziehgriff in Querrichtung weitgehend biegesteif bleibt.

Alternativ oder zusätzlich kann auch eine elastische Verbindung zwischen der Zunge und dem Hebelziehgriff bzw. dem Griffarm ausgebildet sein. Eine derartige Verbindung könnte beispielsweise durch ein Federgelenk ermöglicht werden. In diesem Fall kann die Zunge auch aus starrem oder weniger elastischem Material bestehen.

In einer bevorzugten Ausführungsform der erfindungsgemäßen Steckbaugruppe ist ein Spalt zwischen einem freien Ende der Zunge und dem Griffarm ausgebildet. Dadurch kann der Griffarm bzw. der Hebelziehgriff um das Maß des Spaltes in Richtung der Frontplatte über die Soll-Endposition des Hebelziehgriffes hinaus gedrückt werden. Die elastische Zunge ermöglicht ein Weiterverschwenken des Hebelziehgriffs über die Soll-Endposition hinaus, bis der Griffarm federnd gegen das freie Ende der Zunge gedrückt wird. Die Zunge bleibt dabei an der Frontplatte anliegen bzw. anhaften. Auf die Frontplatte, an der die Zunge anliegt, wird die vom Griffarm des Hebelziehgriffs ausgeübte Kraft gedämpft und verringert übertragen. Erst wenn der Griffarm an der Zunge anliegt, wird die vom Griffarm ausgeübte Kraft vollständig auf die Frontplatte der Steckbaugruppe übertragen und der Hebelweg des Hebelziehgriffs beschränkt.

Bevorzugterweise ist der Spalt zwischen dem freien Ende der Zunge und dem Griffarm so ausgebildet, dass die Zunge im Wesentlichen parallel zum Griffarm liegt. Der Spalt zwischen Zunge und Griffarm kann auf einfache Weise durch Einbringen eines Schlitz in den Griffarm hergestellt werden. Dies kann beispielsweise durch Sägen oder per Laserschnitt geschehen.

Durch geeignete Wahl des Spalts zwischen Zunge und Griffarm wird der mögliche Überhub, also die Bewegung des Griffarms über die Soll-Endposition hinaus, festgelegt. Der Spalt hat eine Größe von etwa 0,2 bis 2,0 mm; vorzugsweise ist er so dimensioniert, dass ein Überhub in der Größenordnung von 0,5 mm bis 1,0 mm möglich wird. Diese Spaltenbreite ist ausreichend, damit die auf der Rückseite der Steckbaugruppe angeordneten Stecker in die Steckverbinder der Backplane zuverlässig eingeschoben werden können.

Gerade durch geschickte Auslegung des Schlitzes zwischen Zunge und Griffarm wird erreicht, dass Fehlbedienungen des Hebelziehgriffs oder Beschädigungen der Steckbaugruppe und/oder des Hebelziehgriffs vermieden werden.

Bevorzugt haftet die Zunge des Hebelziehgriffs an der Frontplatte magnetisch an. Damit wird der Hebelziehgriff auf einfache Weise in seiner Position gehalten. Die magnetische Haftverbindung ermöglicht aber gleichzeitig ein komfortables Lösen. Der Bediener, der den Hebelziehgriff am Griffarm angreift, muss nur die Magnetkraft zwischen Zunge und Frontplatte überwinden und kann den Hebelziehgriff dann von der Frontplatte wegschwenken, so dass die Steckbaugruppe auf dem Baugruppenträger entfernt bzw. herausgezogen werden kann. Es ist keine mechanische Sperre, kein zusätzlicher Hebel oder Nippel zu betätigen. Daher ist das Lösen des Hebelziehgriffs aus seiner Soll-Endposition sehr einfach. Gleichzeitig gewährleistet die magnetische Verbindung einen zuverlässigen Halt des Hebels in seiner Soll-Endposition.

In einer vorteilhaften Ausgestaltungsform der erfindungsgemäßen Steckbaugruppe ist an der Frontplatte ein abstehender Anschlag ausgebildet, der magnetisierbar ist. Der Anschlag ist in dem Bereich angeordnet, in dem das freie Ende der Zunge angeordnet ist, wenn sich der Hebelziehgriff in seiner Soll-Endposition befindet. Zumindest das freie Ende der Zunge besteht dann aus ferromagnetischem Material.

Durch diese Ausgestaltung liegt das freie Ende der Zunge an dem magnetischen Anschlag an und wird von diesem gehalten, wenn sich der Hebelziehgriff in seiner Soll-Endposition befindet. Selbstverständlich kann auch die gesamte Zunge oder der gesamte Hebelziehgriff aus ferromagnetischem Material bestehen. Dabei eignet sich ein eisenhaltiger Stahl oder eine Stahllegierung.

Der abstehende Anschlag kann als kleiner Magnet ausgebildet sein. Durch die Größe des Anschlags und durch die Wahl des magnetisierbaren Materials wird die Haftkraft der magnetischen Verbindung zwischen Zunge und Anschlag festgelegt. Der Anschlag kann in Form einer Nase oder eines kleinen Knopfes an der Frontplatte ausgebildet sein. Diese kann beispielsweise in einem in der Frontplatte vorgesehenem Gewindeloch eingeschraubt werden. Auch ist es möglich den Anschlag anzuschweißen oder auf andere Art mit der Frontplatte zu verbinden. Der abstehende Anschlag hat den Vorteil, dass die Form des Hebelziehgriff so gewählt werden kann, dass sich der Hebelziehgriff in seiner Soll-Endposition im Wesentlichen parallel zur Frontplatte erstreckt. Durch den Abstand zwischen Hebelziehgriff und Frontplatte, der durch die Größe des Anschlags bestimmt wird, wird ein Spalt gebildet, so dass der Benutzer den Hebelziehgriff komfortabel betätigen kann.

Selbstverständlich ist es auch möglich, den Anschlag der Frontplatte aus eisenhaltigem oder ferromagnetischem Material auszubilden und zumindest das freie Ende der Zunge aus magnetisierbarem bzw. magnetischem Material.

Vorzugsweise weist die Zunge im Bereich ihres freien Endes einen Stößel auf, der einen hinter der Frontplatte angeordneten Schalter kontaktiert. Die Anordnung des Stößels an der Zunge des Griffarms gewährleistet, dass die Leiterplatte aktiv geschaltet wird, sobald der Hebelziehgriff seine Soll-Endposition erreicht hat. Die Elastizität der Zunge stellt sicher, dass auf den Hebelziehgriff ausgeübte Kräfte nur gedämpft auf den Stößel und damit auf den Schalter der Leiterplatte übertragen werden. Somit wird ein zuverlässiger Schutz vor Beschädigungen oder Zerstörungen des Schalters beim Einschieben der Steckbaugruppe in den Baugruppenträger gewährleistet; gleichzeitig bleibt die sichere Kontaktierung und das Betätigen des Schalters bestehen.

Beim Herausziehen der Steckbaugruppe aus dem Baugruppenträger wird der Schalter ebenfalls durch den Stößel geschaltet, so dass die Steckbaugruppe passiv wird, sobald die Zunge aus ihrer Soll-Endposition bewegt wird. Im Fall einer magnetischen Haftverbindung zwischen Zunge und Anschlag an der Frontplatte der Steckbaugruppe wird die Steckbaugruppe passiv geschaltet, wenn die magnetische Verbindung gelöst, also die magnetische Haftkraft überwunden wird.

Damit der Stößel an der Zunge des Griffarms den hinter der Frontplatte angeordneten Schalter kontaktieren kann, weist die Frontplatte eine Ausnehmung oder einen Ausschnitt auf, so dass der Stößel durch diese Ausnehmung in den Innenraum der Steckbaugruppe hineinragen kann.

In einer vorteilhaften Weiterbildung der erfindungsgemäßen Steckbaugruppe ist die Zunge des Hebelziehgriffs mäanderförmig ausgebildet. Durch die mäanderförmige Ausbildung der Zunge wird ihre Elastizität vergrößert. Damit ist es einfacher, den Hebelziehgriff über seine Soll-Endposition hinaus zu bewegen. Der Überhub lässt sich einfacher realisieren. Gleichzeitig werden auf den Hebelziehgriff auftretende Kräfte stärker gedämpft. Beschädigungen der Frontplatte oder der Steckbaugruppe werden sehr zuverlässig vermieden.

Insbesondere, wenn an der Zunge des Hebelziehgriffs ein Stößel zur Betätigung eines Schalters auf der Steckbaugruppe angeordnet ist, erweist sich die mäanderförmige Ausbildung der Zunge als sehr vorteilhaft. Auf den Schalter ausgeübte Kräfte werden deutlich reduziert, da die Zunge leicht verbiegbar ist. Auf diese Weise wird der Schalter besonders zuverlässig vor Beschädigungen geschützt.

Bevorzugte Ausführungsbeispiele werden anhand der beiliegenden Zeichnungen detailliert beschrieben. Es zeigen:
- Figur 1: einen Längsschnitt durch einen Baugruppenträger mit einer Steckbaugruppe;
- Figur 2: eine Detailansicht der unteren vorderen Ecke der Steckbaugruppe aus Figur 1 mit einem Hebelziehgriff ;
- Figur 3: eine alternative Ausführungsform des Hebelziehgriffs;
- Figur 4: eine Detailansicht der unteren Ecke der Steckbaugruppe mit dem Hebelziehgriff aus Figur 3 im eingeschobenen Zustand;
- Figur 5: eine Detailansicht der unteren vorderen Ecke der Steckbaugruppe in Überhub-Position; und
- Figur 6: eine weitere Alternative des Hebelziehgriffs.

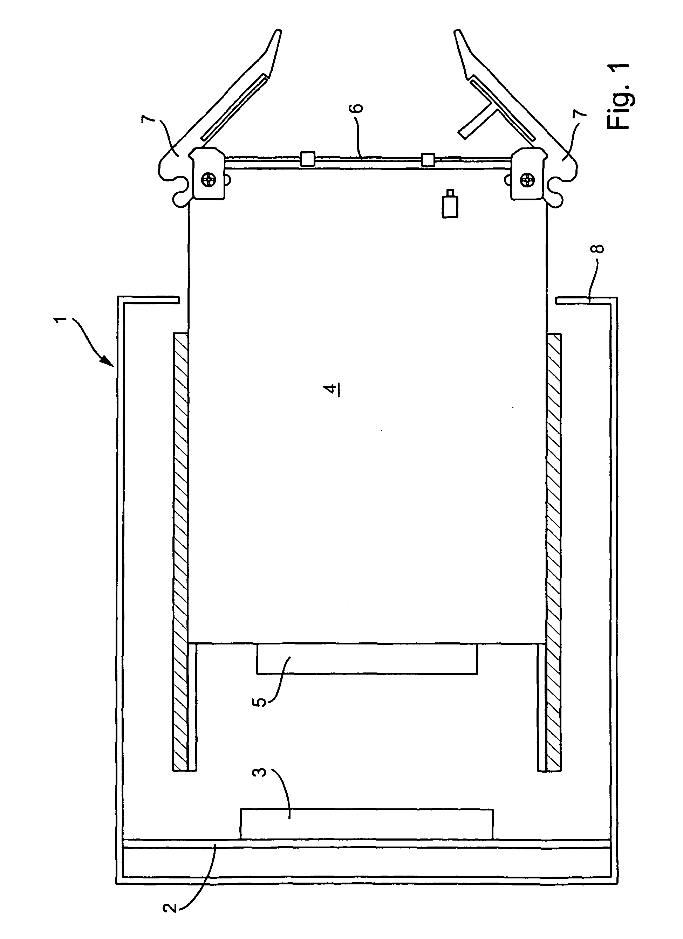

In Figur 1 ist ein Baugruppenträger 1 dargestellt, der in seinem Rückbereich eine Rückverdrahtungsplatine 2 umfasst. An der Rückverdrahtungsplatine 2 ist eine Steckerleiste 3 angeordnet. Eine Steckbaugruppe 4 hat auf ihrer Rückseite einen Stecker 5, der im eingeschobenen Zustand der Steckbaugruppe 4 eine Steckverbindung mit der Steckerleiste 3 herstellt.

Die Steckbaugruppe 4 weist in ihrem vorderen Bereich eine Frontplatte 6 auf. An der oberen und unteren Ecke der Frontplatte 6 ist jeweils ein Hebelziehgriff 7 angeordnet. Zum Einschieben und Herausziehen der Steckbaugruppe 4 in bzw. aus dem Baugruppenträger 1 greift der Hebelziehgriff 7 in eine vordere Profilschiene 8 des Baugruppenträgers 1 ein.

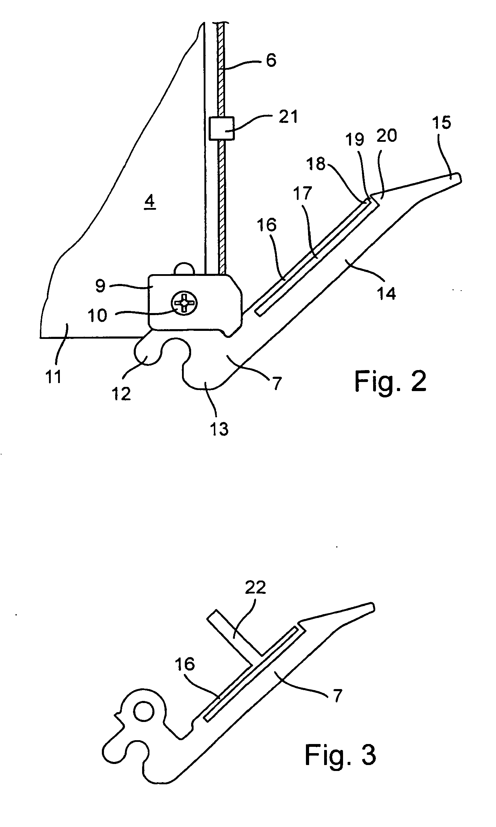

In Figur 2 ist die vordere untere Ecke der Steckbaugruppe 4 mit dem Hebelziehgriff 7 im Detail dargestellt. In der unteren Ecke der Steckbaugruppe 4 ist ein Befestigungsadapter 9 angeordnet. Der Befestigungsadapter 9 weist ein Drehlager 10 in Form einer Schraube auf, um welches der Hebelziehgriff 7 schwenkbar ist. Die Schraube fixiert den Befestigungsadapter 9 mit der Frontplatte 6 und einer Leiterplatte 11 der Steckbaugruppe 4.

Der Hebelziehgriff 7 ist in seinem unteren Ende nahe des Drehlagers 10 als Sporn 12 ausgebildet. Der Sporn 12 greift bei vollständig in den Baugruppenträger 1 eingeschobener Steckbaugruppe 4 in die Profilschiene 8 ein. Parallel zum Sporn 12 weist der Hebelziehgriff 7 eine Abdrückschulter 13 auf, die der Steckbaugruppe 4 abgewandt ist. Von der Abdrückschulter 13 erstreckt sich ein Griffarm 14 nach oben.

Der Griffarm 14 hat an seinem oberen Ende eine zulaufende, leicht von der Steckbaugruppe 4 weg geneigte Spitze 15, an der der Griffarm 14 vom Benutzer gehalten und betätigt wird. Im mittleren Bereich des Griffarms 14 ist eine parallel verlaufende Zunge 16 angeordnet. Zwischen der Zunge 16 und dem Griffarm 14 ist ein Spalt 17 ausgebildet. Die Zunge 16 ist mit ihrem unteren Ende am Griffarm 14 befestigt. Ein freies Ende 18 der Zunge 16 ist vom Griffarm 14 beabstandet, so dass ein Abstand 19 zwischen der Zunge und einem Vorsprung 20 des Griffarms 14 gebildet wird. Dadurch ist die Zunge 16 in ihrem freien Ende 18 elastisch beweglich. Die Elastizität der Zunge 16 wird dabei in die eine Richtung durch die Breite des Spalts 17 begrenzt.

An der Frontplatte 6 ist in dem Bereich, in dem das freie Ende 18 der Zunge 16 angeordnet ist, wenn der Hebelziehgriff 7 in seine Soll-Endposition parallel zur Frontplatte 6 geschwenkt ist, ein Anschlag 21 angeordnet. Der Anschlag 21 ist an der Frontplatte 6 angeschraubt und steht etwas hervor. Wenn der Hebelziehgriff 7 in seine Soll-Endposition verschwenkt ist, liegt die Zunge 16 am Anschlag 21 an.

Der Anschlag 21 ist als Magnet ausgebildet. Das freie Ende 18 der Zunge 16 besteht aus ferromagnetischem Material. Der Hebelziehgriff 7 wird deshalb durch die magnetische Verbindung zwischen dem Anschlag 21 und der Zunge 16 in seiner Soll-Endposition fixiert.

Figur 3 zeigt eine weitere Ausführungsform des Hebelziehgriff 7, bei der die Zunge 16 des Hebelziehgriffs 7 einen Stößel 22 aufweist. Der im Bereich des freien Endes 18 der Zunge 16 angeordnete Stößel 22 ist im rechten Winkel zur Zunge 16 angeordnet. Der Stößel 22 ist etwa 10 bis 15 mm lang. Er dient zur Betätigung eines Mikroschalters auf der Steckbaugruppe, um die Steckbaugruppe aktiv bzw. passiv zu schalten.

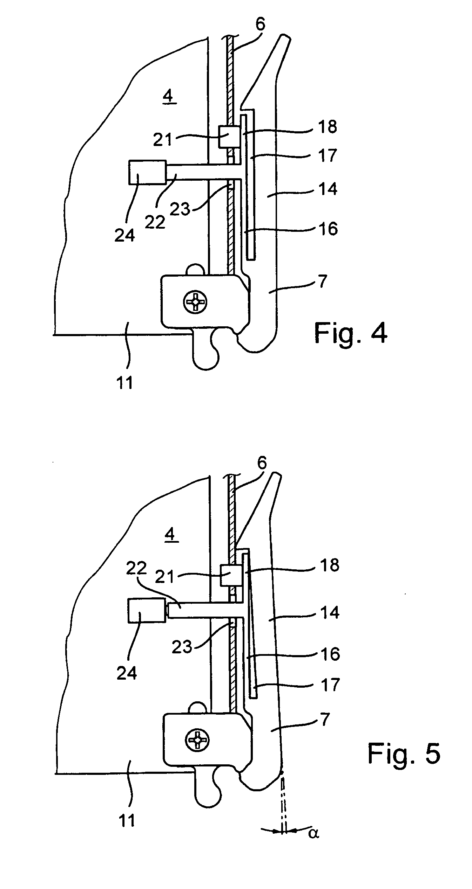

In Figur 4 ist die vordere untere Ecke der Steckbaugruppe mit Hebelziehgriff 7 und Stößel 22 gezeigt, wenn sich der Hebelziehgriff 7 in seiner Soll-Endposition befindet. Die Steckbaugruppe 4 ist dann vollständig in den Baugruppenträger eingeschoben; der Hebelziehgriff 7 ist im Wesentlichen parallel zur Frontplatte 6 ausgerichtet.

Die Frontplatte 6 weist eine Ausnehmung 23 auf, durch die sich der Stößel 22 in den Innenraum hinter der Frontplatte 6 erstreckt. Auf der Leiterplatte 11 der Steckbaugruppe 4 ist ein Mikroschalter 24 angeordnet. Der Stößel 22 betätigt den Mikroschalter 24, so dass die Steckbaugruppe 4 aktiv geschaltet wird, wenn die Steckbaugruppe 4 vollständig in dem Baugruppenträger eingeschoben ist, und passiv geschaltet wird, sobald die Steckbaugruppe 4 aus dem Baugruppenträger herausgezogen wird.

An der Frontplatte 6 der Steckbaugruppe 4 ist oberhalb der Ausnehmung 23 der Anschlag 21 angeordnet. Am Anschlag 21 liegt das freie Ende 18 der Zunge 16 an, da sich der Hebelziehgriff 7 in seiner Soll-Endposition befindet, also der Griffarm 14 parallel zur Frontplatte 6 ausgerichtet ist. Der Anschlag 21 ist als Magnet ausgebildet. Das freie Ende 18 der Zunge 16 besteht aus ferromagnetischem Material, so dass eine magnetische Haltekraft zwischen dem Anschlag 21 und der Zunge 16 entsteht und der Hebelziehgriff 7 in seiner Position gehalten wird.

Um den Hebelziehgriff 7 aus seiner Soll-Endposition von der Frontplatte 6 wegzuschwenken, muss die magnetische Haltekraft zwischen Anschlag 21 und Zunge 16 überwunden werden. Zu Beginn der Schwenkbewegung des Hebelziehgriff 7 wird der Griffarm 14 um einen kleinen Winkel α aus der Vertikalen wegbewegt. Die Zunge 16 verformt sich dabei elastisch, da die Zunge 16 vom magnetischen Anschlag 21 in ihrer Position gehalten wird. Der Spalt 17 zwischen der Zunge 16 und dem Griffarm 14 vergrößert sich im Bereich des freien Endes 18 der Zunge 16. Bei einer Weiterbewegung des Hebelziehgriffs 7 wird dann die magnetische Haltekraft zwischen Anschlag 21 und Zunge 16 überwunden. Die Zunge 16 löst sich vom Anschlag 21; der Hebelziehgriff wird in die Horizontale verschwenkt und die Steckbauruppe 4 aus dem Baugruppenträger herausgezogen. Der Benutzer muss keine weitere Sperre oder Entriegelung bedienen. Der Hebelziehgriff 7 kann auf komfortable Weise betätigt werden; gleichzeitig wird er jedoch sicher und zuverlässig in seiner Soll-Endposition fixiert.

Figur 5 zeigt die Steckbaugruppe 4 mit dem Hebelziehgriff 7, wenn der Hebelziehgriff 7 über seine Soll-Endposition hinaus in Richtung Frontplatte 6 verschwenkt ist. Der Griffarm 14 des Hebelziehgriffs 7 ist dann um den Winkel α gegenüber der Vertikalen verschwenkt.

Während des Verschwenkens des Hebelziehgriffs 7 über die Soll-Endposition hinaus wird die auf den Hebelziehgriff 7 bzw. den Griffarm 14 ausgeübte Kraft von der elastisch ausgebildeten Zunge 16 gedämpft bis die in Figur 5 gezeigte maximale Endposition erreicht wird. Die Zunge 16 bleibt dabei stets am Anschlag 21 anliegen. Der Spalt 17 zwischen der Zunge 16 und dem Griffarm 14 wird soweit verringert bis der Griffarm 14 am freien Ende 18 der Zunge 16 anliegt. Beschädigungen der Frontplatte 6 und der Steckbaugruppe 4 werden auf diese Weise während des Verschwenkens über die Soll-Endposition hinaus zuverlässig verhindert. Auch wird die auf den Griffarm 14 ausgeübte Kraft nicht auf den Stößel 22 und den vom Stößel 22 betätigten Mikroschalter 24 auf der Leiterplatte 11 übertragen. Der Mikroschalter 24 ist somit sicher vor zu hohen Kräften geschützt.

Die Schwenkbewegung des Hebelziehgriffs 7 wird durch die Zunge 16 begrenzt. Die Schwenkbewegung kann nur entsprechend der Breite des Spaltes 17 über die Soll-Endposition hinaus ausgeführt werden. Durch den Überhub des Hebelziehgriffs 7 wird die Steckbaugruppe 4 sicher und zuverlässig im Baugruppenträger positioniert und die Steckverbindung zwischen dem Stecker der Steckbaugruppe und der Steckerleiste an der Backplane des Baugruppenträgers hergestellt. Dazu ist eine Spaltbreite von 0,2 bis 2,0 mm ausreichend; vorzugsweise beträgt die Spaltbreite 0,5 mm bis 1,0 mm.

Sobald der Hebelziehgriff 7 nicht mehr durch eine zusätzliche Kraft über die Soll-Endposition in Richtung Frontplatte 6 gedrückt wird, wird der Griffarm 14 durch die elastische Zunge 16 von der Frontplatte 6 wegbewegt. Dieser Vorgang findet aufgrund der elastischen Ausbildung der Zunge 16 statt. Der Hebelziehgriff 7 wird also federnd in seine Soll-Endposition zurückbewegt, wie in Figur 4 dargestellt. Dieses Rückfedern des Hebelziehgriff 7 hat aber keinen Einfluss auf die Positionierung der Steckbaugruppe 4 im Baugruppenträger, so dass die Steckbaugruppe 4 im eingeschobenen Zustand verbleibt. Auch bleibt die Zunge 16 in ihrer Position und deshalb die Steckbaugruppe 4 aktiv geschaltet, da der Mikroschalter 24 nach wie vor vom Stößel 22 betätigt ist.

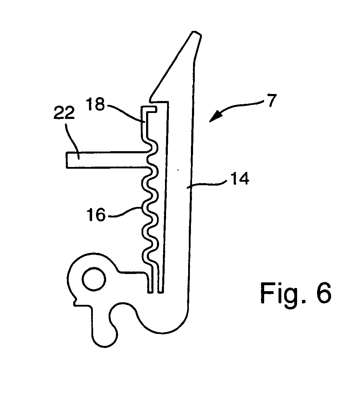

Figur 6 zeigt eine weitere alternative Ausführungsform des Hebelziehgriffs 7. Bei diesem Hebelziehgriff 7 ist die parallel zum Griffarm 14 angeordnete Zunge 16 mäanderförmig ausgebildet. Dabei ist insbesondere der Bereich der Zunge 16 zwischen der Befestigung der Zunge 16 am Hebelziehgriff 7 und dem Stößel 22 in Form eines Mäanders gebildet. Auf diese Weise wird eine höhere Elastizität der Zunge 16 erzielt. Auf den Hebelziehgriff 7 ausgeübte Kräfte werden stärker gedämpft. Der Hebelziehgriff 7 kann einfacher über seine Soll-Endposition hinaus in Richtung Steckbaugruppe geschwenkt werden. Das Herstellen einer Steckverbindung zwischen Steckbaugruppe und Baugruppenträger wird vereinfacht.

Das freie Ende 18 der Zunge 16 ist nicht mäanderförmig ausgebildet. In diesem Bereich ist die Zunge 16 gerade, so dass sie definiert und zuverlässig an dem Anschlag der Steckbaugruppe anhaften kann und eine gewünschte Haftkraft zwischen Zunge 16 und Steckbaugruppe auftritt.

### Zusammenstellung der Bezugszeichen

- 1: Baugruppenträger
- 2: Rückverdrahtungsplatine
- 3: Steckerleiste
- 4: Steckbaugruppe
- 5: Stecker
- 6: Frontplatte
- 7: Hebelziehgriff
- 8: Profilschiene
- 9: Befestigungsadapter
- 10: Drehlager
- 11: Leiterplatte
- 12: Sporn
- 13: Abdrückschulter
- 14: Griffarm
- 15: Spitze
- 16: Zunge
- 17: Spalt
- 18: freies Ende
- 19: Abstand
- 20: Vorsprung
- 21: Anschlag
- 22: Stößel
- 23: Ausnehmung
- 24: Mikroschalter

## Patentansprüche

1. Steckbaugruppe zum Einschieben und Ausziehen in bzw. aus einem Baugruppenträger (1), der wenigstens eine vordere Profilschiene (8) aufweist, mit
- einer Frontplatte (6); und
- einem im Frontbereich der Steckbaugruppe (4) schwenkbar gelagerten Hebelziehgriff (7) mit einem Griffarm (14),
**dadurch gekennzeichnet, dass** der Griffarm (14) des Hebelziehgriffs (7) eine elastische Zunge (16) aufweist, die in eingeschobenem Zustand der Steckbaugruppe (4) von außen an der Frontplatte (6) anhaftet, wodurch der Hebelziehgriff (7) in seiner Soll-Endposition fixiert ist.

2. Steckbaugruppe nach Anspruch 1, **dadurch gekennzeichnet, dass** die Zunge (16) aus elastisch verformbarem Material besteht.

3. Steckbaugruppe nach Anspruch 1 oder 2, **dadurch gekennzeichnet, dass** ein Spalt (17) zwischen einem freien Ende der Zunge (16) und dem Griffarm (14) ausgebildet ist, wodurch der Griffarm (14) um das Maß des Spaltes (17) in Richtung der Frontplatte (6) über seine Soll-Endposition hinaus drückbar ist.

4. Steckbaugruppe nach einem der Ansprüche 1 bis 3, **dadurch gekennzeichnet, dass** die Zunge (16) an der Frontplatte (6) magnetisch anhaftet.

5. Steckbaugruppe nach einem der Ansprüche 1 bis 4, **dadurch gekennzeichnet, dass** an der Frontplatte (6) ein abstehender Anschlag (21) ausgebildet ist, der magnetisierbar ist und der bei in Soll-Endposition befindlichem Hebelziehgriff (7) im Bereich des freien Endes der Zunge (16) angeordnet ist, und zumindest das freie Ende der Zunge (16) aus ferromagnetischem Material besteht.

6. Steckbaugruppe nach einem der Ansprüche 1 bis 5, **dadurch gekennzeichnet, dass** die Zunge (16) im Bereich ihres freien Endes einen Stößel (22) aufweist, der einen hinter der Frontplatte (6) angeordneten Schalter kontaktiert.

7. Steckbaugruppe nach einem der Ansprüche 1 bis 6, **dadurch gekennzeichnet, dass** die Zunge (16) mäanderförmig ausgebildet ist.

## Claims

1. A plug-in module for insertion and extraction into and out of a subrack (1), which has at least one front profile rail (8), comprising
- a front plate (6); and
- a lever pull handle (7) with a handle arm (14), supported so as to rotate in the front region of the plug-in module (4),
**characterised in that** the handle arm (14) of the lever pull handle (7) has an elastic tongue (16), that in the inserted state of the plug-in module (4) adheres from the exterior to the front plate (6), whereby the lever pull handle (7) is fixed in its desired end position.

2. A plug-in module according to Claim 1, **characterised in that** the tongue (16) is composed of an elastically deformable material.

3. A plug-in module according to Claim 1 or 2, **characterised in that** a gap (17) is formed between a free end of the tongue (16) and the handle arm (14), whereby the handle arm (14) can be pressed beyond its desired end position in the direction of the front plate (6) by the dimension of the gap (17).

4. A plug-in module according to one of Claims 1 through 3, **characterised in that** the tongue (16) magnetically adheres to the front plate (6).

5. A plug-in module according to one of Claims 1 through 4, **characterised in that** on the front plate (6), a projecting stop (21) is formed which can be magnetised, and which is arranged in the region of the free end of the tongue (16) with the lever pull handle (7) located in the desired end position, and that at least the free end of the tongue (16) is composed of a ferromagnetic material.

6. A plug-in module according to one of Claims 1 through 5, **characterised in that** the tongue (16) has in the region of its free end a tappet (22), which contacts the switch arranged behind the front plate (6).

7. A plug-in module according to one of Claims 1 through 6, **characterised in that** the tongue (16) is of sinuous shape.

## Revendications

1. Module enfichable pour l'insertion et le retrait dans ou d'un châssis(1), qui présente au moins un rail profilé avant (8), comprenant
- une platine frontale (6), et
- une poignée d'extraction à levier (7) avec un bras de prise (14), montée pivotante dans la zone frontale du module enfichable (4),
**caractérisé en ce que** le bras de prise (14) de la poignée d'extraction à levier (7) présente une languette élastique (16), qui adhère de l'extérieur sur la platine frontale (6) dans l'état d'insertion du module enfichable (4), la poignée d'extraction à levier (7) étant de ce fait fixée dans sa position finale de consigne.

2. Module enfichable suivant la revendication 1, **caractérisé en ce que** la languette (16) est constituée d'un matériau déformable élastiquement.

3. Module enfichable suivant la revendication 1 ou 2, **caractérisé en ce qu'**une fente (17) s'étend entre une extrémité libre de la languette (16) et le bras de prise (14), le bras de prise (14) pouvant être de ce fait pressé au-delà de sa position finale de consigne, de la dimension de la fente (17), en direction de la platine frontale (6).

4. Module enfichable suivant l'une des revendication 1 à 3, **caractérisé en ce que** la languette (16) adhère sur la platine frontale (6) magnétiquement.

5. Module enfichable suivant l'une des revendications 1 à 4, **caractérisé en ce qu'**une butée en saillie (21) est réalisée sur la platine frontale (6), laquelle butée est magnétisable et est disposée dans la zone de l'extrémité libre de la languette (16) lorsque la poignée d'extraction à levier (7) se situe en position finale de consigne, et au moins l'extrémité libre de la languette (16) est constituée de matériau ferromagnétique.

6. Module enfichable suivant l'une des revendications 1 à 5, **caractérisé en ce que** la languette (16) présente dans la zone de son extrémité libre un poussoir (22), qui contacte un interrupteur disposé derrière la platine frontale (6).

7. Module enfichable suivant l'une des revendications 1 à 6, **caractérisé en ce que** la languette (16) s'étend en forme de méandre.
